# EUROPEAN PATENT APPLICATION

(11) **EP 4 757 556 A1**
(43) Date of publication of application: **10.06.2026**
(21) Application number: 24852238.5
(22) Date of filing: 02.08.2024
(51) Int. Cl.: H10K 59/121, H10K 71/20, H10K 59/122, H10K 59/35, H10K 59/80, H10K 59/12

(54) **ORGANIC LIGHT-EMITTING DISPLAY DEVICE**

(30) Priority: 04.08.2023 KR 20230102412; 09.11.2023 KR 20230154628; 11.06.2024 KR 20240075900; 17.07.2024 KR 20240094563
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/011451
(87) International publication number: WO 2025/033884

(57) **Abstract**

An organic light-emitting display device may include a bank between subpixels on a substrate, an anode electrode on the subpixel, an organic light-emitting layer on the anode electrode and the bank, a cathode electrode on the organic light-emitting layer, and a protrusion part disposed on an upper side of the bank so as to be spaced apart from the organic light-emitting layer. The protrusion part may include a connection structure including an auxiliary electrode in contact with the cathode electrode, and a bridge electrode disposed on the connection structure to be electrically connected to the auxiliary electrode.

## Description

### [Technical Field]

The embodiment relates to an organic light-emitting display device.

### [Background Art]

As the demand for portable information media increases, an attempt to apply an organic light-emitting display device to various lightweight and thin information electronic devices is expanding. Recently, the organic light-emitting display device is being applied to product groups such as a mobile PC and an automobile rather than TV or a mobile phone. Since the organic light-emitting display device applied to the mobile PC and the automobile is driven as still image for a long time, long lifespan is required. In order to have the long lifespan, the extraction of light from the organic light-emitting element must be maximized. In addition, in order to reduce the cost, it is necessary to expand the technology to be able to produce organic light-emitting elements on a substrate 110 of not only 8.5^{th} generation (2200x2,500mm) but also 10.5^{th} generation (3370x2940mm). In order to produce long-life organic light-emitting element, each subpixel with a top emission structure and a side-by-side structure must be implemented as a structure of an organic light-emitting element with two or more stacks.

The structure of such an organic light-emitting element may be obtained through a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low pixel position accuracy (PPA) between the FMM and the substrate. Accordingly, the emission area ratio (EAR) is small, which limits the product lifespan. Here, the emission area ratio is the value obtained by dividing the emission area of the subpixel by the area of the subpixel.

Therefore, the development of a new deposition method to solve the aforementioned problems and an organic light-emitting display device having a new structure of the organic light-emitting element using the new deposition method is very urgent.

### [Disclosure]

### [Technical Problem]

An object of the embodiment is to solve the foregoing and other problems.

Another object of the embodiment is to provide an organic light-emitting display device having a novel structure.

Another object of the embodiment is to provide an organic light-emitting display device capable of improving the lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that may be understood through the description of the invention.

### [Technical Solution]

In order to achieve the above or other objects, according to one aspect of the embodiment, an organic light-emitting display device, comprising: a bank between subpixels on a substrate; an anode electrode on the subpixel; an organic light-emitting layer on the anode electrode and the bank; a cathode electrode on the organic light-emitting layer; and a protrusion part disposed on an upper side of the bank so as to be spaced apart from the organic light-emitting layer; wherein the protrusion part comprises: a connection structure comprising an auxiliary electrode in contact with the cathode electrode; and a bridge electrode disposed on the connection structure to be electrically connected to the auxiliary electrode.

The protrusion part may comprise a first layer on the bank, a second layer on the first layer, and a third layer below the first layer. A side portion of the third layer may be positioned on a same line or diagonal line as a side portion of the second layer or may extend from the side portion of the second layer in a direction of the subpixel. A side portion of the first layer may be recessed into the inside of the protrusion part from the side portion of the second layer.

The bridge electrode may comprise a first bridge electrode on the second layer and a second bridge electrode disposed on the first bridge electrode to be electrically connected to the first bridge electrode.

The first bridge electrode may be a connection electrode for connecting the auxiliary electrode to the second bridge electrode.

The protrusion part may further comprise a fourth layer between the second layer and the first bridge electrode.

The first bridge electrode may be disposed on a lower side of the second layer via a side portion of the fourth layer.

At least one or more of the first bridge electrode or the fourth layer may comprise an etch-stop layer.

At least one of the first layer, the second layer, or the third layer may be the auxiliary electrode.

The protrusion part may be disposed on the connection structure, and may comprise a sensing element for touch sensing.

The sensing element may comprise a first sensing electrode on the second layer, a second sensing electrode on the first sensing electrode, and a permittivity layer having a predetermined permittivity between the first sensing electrode and the second sensing electrode.

One of the first sensing electrode and the second sensing electrode may supply a driving signal, and the other may output a sensing signal corresponding to the driving signal.

The organic light-emitting display device may further comprise a black resin layer on the bridge electrode.

The auxiliary electrode and the bridge electrode may be commonly connected to a power line.

The organic light-emitting display device may further comprise an open structure configured to induce a hole injection layer of the organic light-emitting layer to be isolated in the bank.

### [Advantageous Effects]

The effects of the organic light-emitting display device according to the embodiment are described as follows.

According to at least one of the embodiments, there is an advantage that the process can be simplified and the process cost can be reduced because there is no need to use an FMM.

According to at least one of the embodiments, there is an advantage that the EAR within a subpixel can be increased because there is no need to use an FMM, so that the lifespan can be improved.

According to at least one of the embodiments, there is an advantage that productivity, yield, and material utilization efficiency can be improved by depositing an organic light-emitting element on a large-area substrate in an in-line deposition system.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a schematic plan view illustrating an organic light-emitting display device according to a first embodiment.
FIG. 2 is a plan view illustrating one pixel of FIG. 1.
FIG. 3 is a circuit diagram illustrating an organic light-emitting display device according to an embodiment.
FIG. 4A is a cross-sectional view taken along line A-A' in the pixel of FIG. 2.
FIG. 4B is a cross-sectional view taken along line B-B' in the pixel of FIG. 2.
FIG. 4C is a cross-sectional view taken along line C-C' in the pixel of FIG. 2.
FIG. 5 is a cross-sectional view illustrating an organic light-emitting display device according to a first embodiment.
FIG. 6 is a cross-sectional view illustrating an organic light-emitting display device according to a second embodiment.
FIG. 7 is a cross-sectional view illustrating an organic light-emitting display device according to a third embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

Hereinafter, an organic light-emitting display device having a side-by-side structure manufactured using a photolithography process is disclosed. This structure is referred to as Ph-SbS (side-by-side structure by photolithography). By using a photolithography process, the process may be simplified and the process cost may be reduced because there is no need to use an FMM. In addition, the EAR within the subpixel may be increased, so that the lifespan may be improved. In addition, since the organic light-emitting element is deposited on a large-area substrate in an in-line deposition system, productivity, yield and material utilization efficiency may be improved.

Hereinafter, a red subpixel SPr may be named a first subpixel, a green subpixel SPg may be named a second subpixel, and a blue subpixel SPb may be named a third subpixel. In addition, the red organic light-emitting element 120r may be named as a first organic light-emitting element, the green organic light-emitting element 120g may be named as a second organic light-emitting element, and the blue organic light-emitting element 120b may be named as a third organic light-emitting element.

Hereinafter, the organic light-emitting display device 100 is a top-emission type in which light is emitted in the upper direction of the substrate 110 to display an image, but a bottom-emission type that displays an image by emitting light in the lower direction of the substrate 110 may also be included in the technical idea of the present invention.

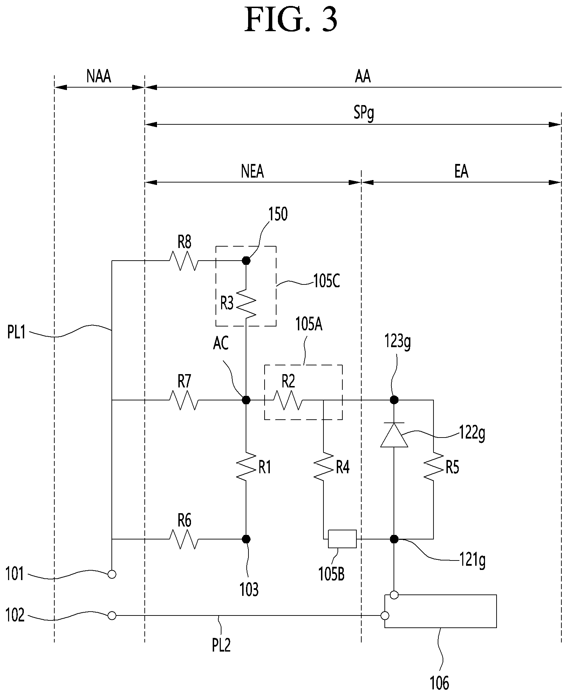

Hereinafter, the drawing reference numeral of the auxiliary electrode may be given as AC as illustrated in FIG. 3 unless a separate drawing reference numeral is given.

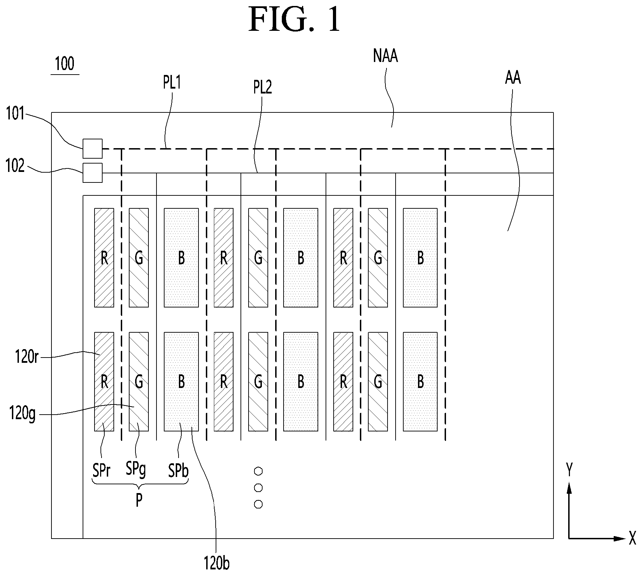

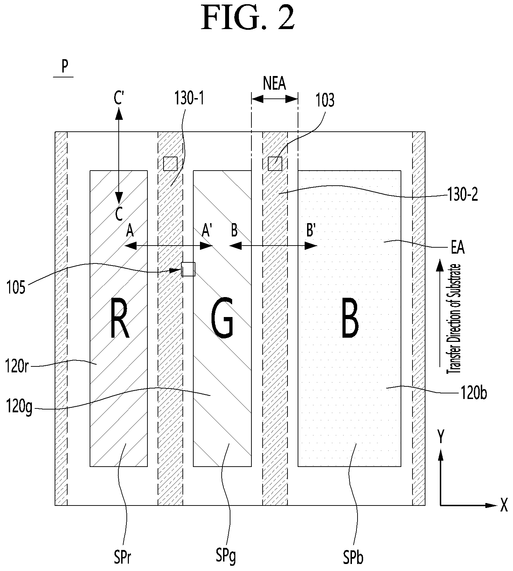

FIG. 1 is a plan view schematically illustrating an organic light-emitting display device according to the first embodiment. FIG. 2 is a plan view illustrating one pixel of FIG. 1.

Referring to FIG. 1 and FIG. 2, the organic light-emitting display device 100 according to the first embodiment may comprise a plurality of pixels P arranged in a matrix. The plurality of pixels P may be positioned in a display region AA. The remaining area excluding the display region AA may be a non-display region NAA.

Each pixel P may comprise, for example, a red subpixel SPr, a green subpixel SPg, and a blue subpixel SPb. For example, a red organic light-emitting element 120r may be disposed in the red subpixel SPr, a green organic light-emitting element 120g may be disposed in the green subpixel SPg, and a blue organic light-emitting element 120b may be disposed in the blue subpixel SPb. Although the drawing illustrates that one pixel P comprises three subpixels SPr, SPg, and SPb, more subpixels may be included.

Although the drawing illustrates that the area of the blue subpixel SPb is greater than the area of the red subpixel SPr or the area of the green subpixel SPg, other variations are possible.

Each of the subpixels SPr, SPg, and SPb may comprise an emission region EA and a non-emission region NEA. The emission region EA may be a region where the organic light-emitting element 120r, 120g, and 120b of each of the subpixels SPr, SPg, and SPb is disposed, and the non-emission region NEA may be the remaining region excluding the emission region EA in each of the subpixels SPr, SPg, and SPb.

Meanwhile, a first power line PL1 and a second power line PL2 may be provided to supply power to each of the subpixels SPr, SPg, and SPb. A first power terminal 101 may be electrically connected to one end of the first power line PL1, and a second power terminal 102 may be electrically connected to one end of the second power line PL2. The first power terminal 101 and the second power terminal 102 may be electrically connected to a power supply unit (not illustrated) to receive a first potential voltage and a second potential voltage. The second potential voltage may be greater than the first potential voltage, and the first potential voltage may be grounded.

The first power line PL1 and the second power line PL2 may be disposed between the non-emission region NEA along a first direction X. The first power line PL1 and the second power line PL2 may be electrically connected to each of the subpixels SPr, SPg, and SPb.

A contact pad 103 may be positioned in the non-emission region NEA. The first power line PL1 may be electrically connected to the contact pad 103.

The auxiliary electrode (AC in FIG. 3) may be positioned in the non-emission region NEA. The auxiliary electrode AC may be positioned in the non-emission region NEA along a second direction Y, but is not limited thereto.

The auxiliary electrode AC may be positioned in the non-emission region NEA adjacent to each of the subpixels SPr, SPg, and SPb. The auxiliary electrode AC may be electrically connected to the first power line PL1 via the contact pad 103.

The first power line PL1, the contact pad 103, and the auxiliary electrode AC may be disposed in different layers.

The auxiliary electrode AC may be electrically connected to cathode electrodes of the adjacent organic light-emitting elements 120r, 120g, and 120b of the adjacent subpixels SPr, SPg, and SPb. For example, when the auxiliary electrode AC is positioned between the red subpixel SPr and the green subpixel SPg, the auxiliary electrode AC may be electrically connected to the cathode electrode of the red organic light-emitting element 120r and the cathode electrode of the green organic light-emitting element 120g.

Therefore, the auxiliary electrode AC may supply the first potential voltage from the first power line PL1 to the cathode electrodes of each of the organic light-emitting elements 120r, 120g, and 120b.

Meanwhile, the second power line PL2 may be electrically connected to ta driving circuit 106 of each of the subpixels SPr, SPg, and SPb, for example, the driving transistor, but is not limited thereto. Accordingly, when a specific subpixel is selected in response to a scan signal provided through a specific gate line, light having a luminance corresponding to a current flowing in a driving transistor of the specific subpixel may be emitted by the first potential voltage of the first power line PL1 and the second potential voltage of the second power line PL2.

The plurality of organic light-emitting elements 120r, 120g, and 120b may be disposed in a stripe shape along the second direction Y. That is, the plurality of organic light-emitting elements 120r, 120g, and 120b may be disposed continuously without being separated along the second direction Y, respectively. For example, the red organic light-emitting element 120r may be disposed continuously along the second direction Y, the green organic light-emitting element 120g may be disposed continuously along the second direction Y, and the blue organic light-emitting element 120b may be disposed continuously along the second direction Y.

As another example, the plurality of organic light-emitting elements 120r, 120g, and 120b may be separated in pixel P units or row-line units along the second direction Y. That is, the red organic light-emitting element 120r may be separated in pixel P units or row-line units along the second direction Y, the green organic light-emitting element 120g may be separated in pixel P units or row-line units along the second direction Y, and the blue organic light-emitting element 120b may be separated in pixel P units or row-line units along the second direction Y.

The red subpixel SPr, the green subpixel SPg, and the blue subpixel SPb may be alternately arranged in column-line units along the first direction X. That is, the red subpixel SPr, the green subpixel SPg, and the blue subpixel SPb having different colors may be sequentially positioned along the first direction X to implement an organic light-emitting display device having a side-by-side structure.

Meanwhile, an asymmetric open-connection (AOC) structure 105 may be positioned in the non-emission region NEA. In an embodiment, the asymmetric open-connection structure 105 may comprise a connection structure 105A and an open structure 105B. Due to the different ratios of depth and gap in the undercut structures of the connection structure 105A and the open structure 105B, it can be named as the asymmetric open-connection structure 105. The depth may represent a width in a horizontal direction of the undercut structure, and the gap may represent a width in a vertical direction of the undercut structure.

As will be described later, a lateral leakage current between a plurality of subpixels SPr, SPg, and SPb may be prevented by the asymmetric open-connection structure 105. The lateral leakage current may mean a leakage current flowing between the adjacent subpixels SPr, SPg, and SPb along the first direction X. In addition, an electrical short between the anode electrode and the cathode electrode in the corresponding subpixels SPr, SPg, and SPb may be prevented by the asymmetric open-connection structure 105. Therefore, by using the asymmetric open-connection structure 105, color spot due to leakage current may be enhanced and luminescence efficiency and luminance may be significantly improved.

The connection structure 105A may be a structure that electrically connects the auxiliary electrode AC to the cathode electrode of each of the organic light-emitting elements 120r, 120g, and 120b. The open structure 105B may be a structure that separates layers comprising a low-resistance organic light-emitting materials of each of the organic light-emitting elements 120r, 120g, and 120b, such as a hole injection layer, a charge generation layer, etc., thereby preventing an electrical short between the anode electrode and the cathode electrode and reducing leakage current between subpixels. The asymmetric open-connection structure 105 may also be called a 'paradoxical open-connection' structure.

FIG. 3 is a circuit diagram illustrating an organic light-emitting display device according to an embodiment. FIG. 3 may be a circuit diagram for an electrical connection from the first power terminal 101 and the second power terminal 102 to the green subpixel SPg in FIG. 2. The circuit diagram illustrated in FIG. 2 may be equally applied to a circuit diagram for an electrical connection from the first power terminal 101 and the second power terminal 102 to the red subpixel SPr or the blue subpixel SPb.

As illustrated in FIG. 3, the first power terminal 101 and the second power terminal 102 may be disposed in the non-display region NAA, and the first power line PL1 and the second power line PL2 may be disposed in the non-display region NAA and the display region AA.

The contact pad 103 may be disposed in the non-emission region NEA and may be electrically connected to the first power line PL1. The first power line PL1 may be electrically connected to the auxiliary electrode AC through the contact pad 103.

The organic light-emitting element 120g may be disposed in the emission region EA of the subpixel SPg, and the connection structure 105A and the open structure 105B may be disposed in the non-emission region NEA. The asymmetric open-connection structure 105 illustrated in FIG. 2 may be configured by the connection structure 105A and the open structure 105B. The auxiliary electrode AC may be electrically connected to the cathode electrode 123g of the organic light-emitting element 120g through the connection structure 105A. The hole injection layer of the organic light-emitting element 120g may be isolated by the open structure 105B, and the anode electrode 121g and the cathode electrode 123g can be electrically disconnected.

Meanwhile, as illustrated in FIG. 3, in the embodiment, the auxiliary electrode AC may be electrically connected to the first power line PL1 via a bridge electrode 150.

In this instance, three current path lines may be formed between the auxiliary electrode AC and the first power line PL3. In the first current path line, the auxiliary electrode AC may be electrically connected directly to the first power line PL1. In the second current path line, the auxiliary electrode AC may be electrically connected to the first power line PL1 via the contact pad 103. In the third current path line, the auxiliary electrode AC may be electrically connected to the first power line PL1 via the bridge electrode 150.

A first current path line, a second current path line, and a third current path line may be connected in parallel with each other between the auxiliary electrode AC and the first power line PL1. Accordingly, the resistances of each of the first current path line, the second current path line, and the third current path line connected in parallel with each other are parallel-calculated, so that the total resistance between the auxiliary electrode AC and the first power line PL1 may be greatly reduced.

Meanwhile, as illustrated in FIG. 3, various resistances may be formed between each component. Each resistance may be defined as follows.
R1: Contact resistance between the contact pad 103 and the auxiliary electrode AC
R2: Resistance between the auxiliary electrode AC and the cathode electrode 123g
R3: Resistance between the auxiliary electrode AC and the bridge electrode 150
R4: Resistance between the anode electrode 121g and the cathode electrode 123g due to the hole injection layer, etc., disposed in the horizontal direction
R5: Resistance between the anode electrode 121g and the cathode electrode 123g due to the plurality of organic light-emitting layers disposed in the vertical direction
R6: Resistance between the first power line PL1 and the contact pad 103
R7: Resistance between the first power line PL1 and the auxiliary electrode AC
R8: Resistance between the bridge electrode 150 and the first power line PL1

Among the above-mentioned resistances, since the hole injection layer, etc., forming the fourth resistance R4 is made of a low-resistance organic light-emitting material, leakage current easily flows through the hole injection layer, etc. When leakage current flows through the hole injection layer, etc., the electrical short between the anode electrode 121g and the cathode electrode 123g may cause light not to be emitted from the corresponding subpixels SPr, SPg, and SPb, or the luminance of the light may be significantly lower than the desired luminance.

In the embodiment, the hole injection layer corresponding to the open structure 105B may be isolated by the open structure 105B, thereby blocking the leakage current flowing through the hole injection layer, etc.

In the embodiment, the cathode electrode 123g may be easily connected to the auxiliary electrode AC through the connection structure 105A, and the deposition area of the organic light-emitting element 120g may be maximized, thereby improving the luminescence efficiency.

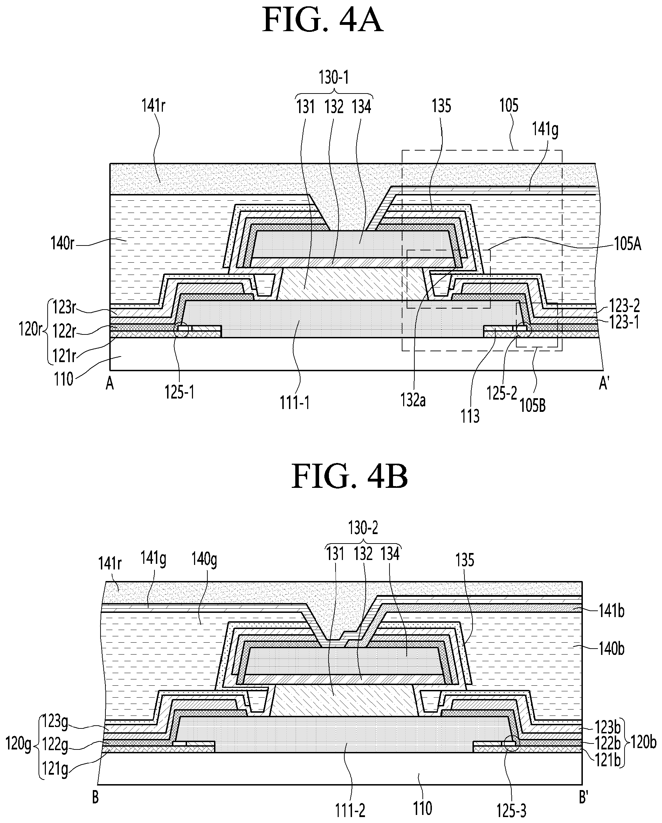

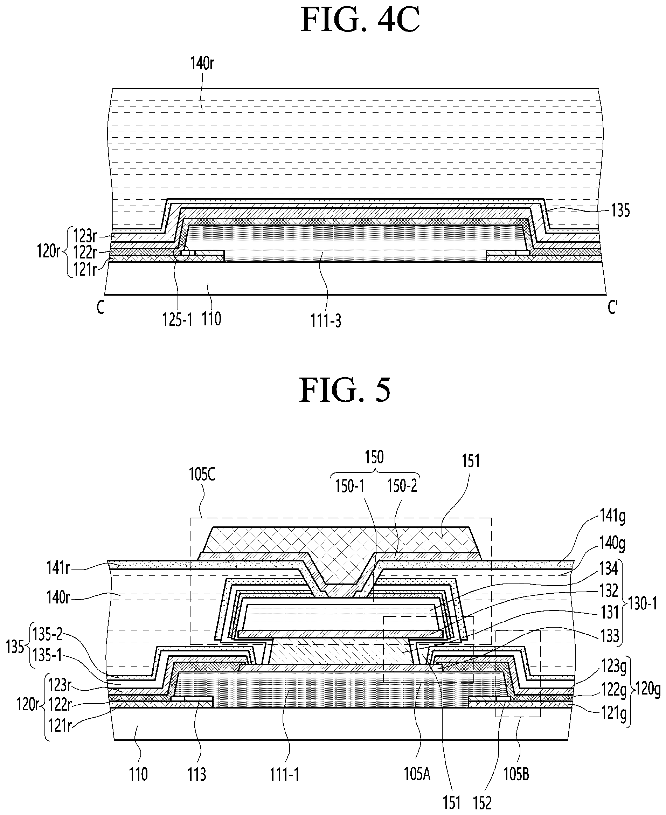

FIG. 4A is a cross-sectional view taken along the line A-A' in the pixel of FIG. 2. FIG. 4B is a cross-sectional view taken along line B-B' in the pixel of FIG. 2. FIG. 4C is a cross-sectional view taken along line C-C' in the pixel of FIG. 2.

Referring to FIG. 1, FIG. 2, and FIG. 4A to FIG. 4C, an organic light-emitting display device according to an embodiment may comprise a plurality of banks 111-1 and 111-2, a plurality of protrusion parts 130-1 and 130-2, a plurality of organic light-emitting elements 120r, 120g, and 120b, etc.

A plurality of banks 111-1 and 111-2, a plurality of protrusion parts 130-1 and 130-2, and a plurality of organic light-emitting elements 120r, 120g, and 120b may be disposed on a substrate 110. A plurality of banks 111-1 and 111-2, a plurality of protrusion parts 130-1 and 130-2, and/or a plurality of organic light-emitting elements 120r, 120g, and 120b may be disposed on the substrate 110 in a stripe shape along the second direction Y, respectively. In this instance, subpixels of the same color may be disposed along the second direction Y. For example, a plurality of red subpixels SPr may be disposed in a stripe shape along the second direction Y. The banks 111-1 and 111-2 may comprise an inorganic material or an organic material. For example, the banks 111-1 and 111-2 may comprise an inorganic material such as SiNx, SiON, etc.

Meanwhile, as illustrated in FIG. 4C, the transverse banks 111-3 may be disposed in a row-line unit along the second direction Y. Alternatively, the protrusion parts may not be disposed in a row-line unit along the second direction Y. That is, the protrusion part along the second direction Y may not be disposed on the transverse bank 111-3.

The first bank 111-1 and the second bank 111-2 may be called longitudinal banks to distinguish them from the transverse bank 111-3.

The plurality of subpixels SPr, SPg, and SPb may be separated from each other by the plurality of banks 111-1 and 111-2. The first bank 111-1 may be disposed between the red subpixel SPr and the green subpixel SPg, and the second bank 111-2 may be disposed between the green subpixel SPg and the blue subpixel SPb. Although not illustrated, the third bank may be disposed between the blue subpixel SPb and another red subpixel SPr.

The plurality of organic light-emitting elements 120r, 120g and 120b may be spatially separated and electrically isolated from each other by the plurality of banks 111-1 and 111-2. Accordingly, the lateral leakage current between the plurality of subpixels SPr, SPg and SPb may be blocked, thereby enhancing color spot and enhancing luminescence efficiency and luminance.

The red organic light-emitting element 120r may be disposed in the red subpixel SPr, the green organic light-emitting element 120g may be disposed in the green subpixel SPg, and the blue organic light-emitting element 120b may be disposed in the blue subpixel SPb.

The plurality of banks 111-1 and 111-2 may have a lattice shape. For example, the banks 111-1 and 111-2 may be disposed along the perimeter of the subpixels SPr, SPg and SPb. That is, the plurality of banks 111-1 and 111-2 may be disposed between the adjacent subpixels SPr, SPg and SPb along the first direction X, and between the adjacent subpixels SPr, SPg and SPb along the second direction Y. In this instance, the adjacent subpixels SPr, SPg and SPb along the first direction X may have different colors, while the adjacent subpixels SPr, SPg and SPb along the second direction Y may have the same color.

The plurality of organic light-emitting elements 120r, 120g and 120b may be separated from each other by the plurality of banks 111-1 and 111-2. The plurality of banks 111-1 and 111-2 may be disposed to distinguish the plurality of organic light-emitting elements 120r, 120g and 120b, respectively. The red organic light-emitting element 120r and the green organic light-emitting element 120g may be separated by the first bank 111-1, and the green organic light-emitting element 120g and the blue organic light-emitting element 120b may be separated by the second bank 111-2.

Meanwhile, the organic light-emitting display device according to the embodiment may comprise an open structure 105B in an edge region of each of the plurality of banks 111-1 and 111-2. For example, the open structure 105B may be disposed in an edge region of the lower side of each of the plurality of banks 111-1 and 111-2, but is not limited thereto.

The open structure 105B may be disposed in an edge region of the banks 111-1 and 111-2 between the subpixels SPr, SPg, and SPb along the first direction X. The open structure 105B may be disposed in the edge region of the banks 111-1 and 111-2 between the subpixels SPr, SPg, and SPb along the second direction Y.

When the organic light-emitting elements 120r, 120g, and 120b are deposited on the banks 111-1 and 111-2, some layers of the organic light-emitting elements 120r, 120g, and 120b may be isolated by the open structure 105B. For example, the open structure 105B may isolate the low-resistance layers of each of the organic light-emitting elements 120r, 120g, and 120b. The low-resistance layers may comprise, for example, a hole injection layer, a charge generation layer, etc. The low-resistance layer may mean a layer having a resistance value lower than the resistance value of a high-resistance layer, for example, an organic light-emitting layer, an electron transport layer, an electron injection layer, etc.

For example, the organic light-emitting layers 122r, 122g and 122b of the organic light-emitting elements 120r, 120g and 120b may have separation structures 125-1 to 125-3 corresponding to the open structure 105B. The separation structures 125-1 to 125-3 may mean a shape in which some layers of the organic light-emitting layers 122r, 122g and 122b are isolated. Accordingly, in the separation structures 125-1 to 125-3, for example, a hole injection layer, a charge generation layer, etc. may isolated.

The open structure 105B may comprise at least one or more blocking layer 113 which is inwardly recessed from the side portion of the banks 111-1 and 111-2. An undercut structure may be formed in the edge region of the banks 111-1 and 111-2 by the blocking layer 113. The blocking layer 113 may comprise, but is not limited to, a silicon-based inorganic material, aluminum (Al), molybdenum (Mo), a molybdenum alloy, etc.

When the organic light-emitting elements 120r, 120g, and 120b are deposited on the banks 111-1 and 111-2 on which the undercut structure is formed in this way, some layers corresponding to the undercut structure, such as the hole injection layer, the charge generation layer, etc., among the organic light-emitting layers 122r, 122g, and 122b of the organic light-emitting elements 120r, 120g, and 120b, may be isolated.

Meanwhile, as described above, organic light-emitting elements 120r, 120g, and 120b corresponding to the subpixels SPr, SPg, and SPb may be disposed, respectively.

The red organic light-emitting element 120r may comprise an anode electrode 121r, a red organic light-emitting layer 122r, a cathode electrode 123r, etc. The red organic light-emitting layer 122r may be disposed on the anode electrode 121r, and the cathode electrode 123r may be disposed on the red organic light-emitting layer 122r. The green organic light-emitting element 120g may comprise an anode electrode 121g, a green organic light-emitting layer 122g, a cathode electrode 123g, etc. The green organic light-emitting layer 122g may be disposed on the anode electrode 121g, and the cathode electrode 123g may be disposed on the green organic light-emitting layer 122g. The blue organic light-emitting element 120b may comprise an anode electrode 121b, a blue organic light-emitting layer 122b, a cathode electrode 123b, etc. The blue organic light-emitting layer 122b may be disposed on the anode electrode 121b, and the cathode electrode 123b may be disposed on the blue organic light-emitting layer 122b.

The anode electrodes 121r, 121g and 121b may comprise a plurality of conductive layers. The anode electrodes 121r, 121g and 121b may have a triple structure composed of ITO/Ag alloy/ITO. The anode electrodes 121r, 121g and 121b may have a triple structure composed of ITO/Ag alloy/(Ti, Mo or MoTi).

One end of anode electrodes 121r, 121g and 121b may be disposed below banks 111-1 and 111-2. That is, one end of the banks 111-1 and 111-2 may be disposed on one end of the anode electrodes 121r, 121g, and 121b. One end of the anode electrodes 121r, 121g, and 121b may vertically overlap with the banks 111-1 and 111-2.

The red organic light-emitting layer 122r, the green organic light-emitting layer 122g, and the blue organic light-emitting layer 122b may comprise at least a hole injection layer comprising a low resistance organic light-emitting material.

Meanwhile, one end of the hole injection layer and/or the charge generation layer may be in contact with the cathode electrode 123r, 123g, and 123b. In addition, the lower surface of the hole injection layer may be in contact with the anode electrode 121r, 121g, and 121b. In this instance, since the resistance of the hole injection layer is small, a leakage current may flow between the anode electrode 121r, 121g, and 121b and the cathode electrode 123r, 123g, and 123b, and an electrical short may occur between the anode electrode 121r, 121g, and 121b and the cathode electrode 123r, 123g, and 123b.

However, according to an embodiment, since the hole injection layer and/or the charge generation layer are isolated by the open structure 105B disposed in the edge region of the bank 111-1 and 111-2, the anode electrode 121r, 121g, and 121b and the cathode electrode 123r, 123g, and 123b may be electrically disconnected, and thus an electrical short may be prevented.

Meanwhile, the organic light-emitting display device according to the embodiment may comprise a plurality of protrusion parts 130-1 and 130-2.

The plurality of organic light-emitting elements 120r, 120g and 120b may be spatially separated and electrically isolated from each other by the plurality of protrusion parts 130-1 and 130-2. Accordingly, the lateral leakage current between the plurality of subpixels SPr, SPg and SPb may be blocked, so that color spot can be enhanced and the luminescence efficiency and luminance may be enhanced.

The plurality of protrusion parts 130-1 and 130-2 may be disposed on the upper side of the plurality of banks 111-1 and 111-2. The first protrusion part 130-1 may be disposed on the upper side of the first bank 111-1 between the red subpixel SPr and the green subpixel SPg. The second protrusion part 130-2 may be disposed on the upper side of the second bank 111-2 between the green subpixel SPg and the blue subpixel SPb.

The left side portion and the right side portion of the protrusion part 130-1 and 130-2 may have shapes that are symmetrical with respect to the center normal of the protrusion part 130-1 and 130-2, but is not limited thereto. For example, the left side portion and the right side portion of the protrusion part 130-1 and 130-2 may each have an undercut structure. In this instance, the undercut structure on the left side portion and the undercut structure on the right side portion may have shapes that are symmetrical with respect to the center normal of the protrusion part 130-1 and 130-2.

The protrusion part 130-1 and 130-2 may have a connection structure 105A comprising an auxiliary electrode AC electrically connected to the cathode electrode 123r, 123g and 123b.

The protrusion part 130-1 and 130-2 may comprise a first layer 131 and a second layer 132 on the first layer 131.

The side portion of the first layer 131 may be recessed into the inside of the protrusion part from the side portion of the second layer 132. Accordingly, an undercut structure may be formed on the side portion of the protrusion part by the first layer 131 and the second layer 132. The undercut structure may have a cave shape. For example, the undercut structure may have a U-cave shape. Accordingly, the undercut structure may be called a cave, a U-cave, a cave portion, etc. In order to form an undercut structure, the first layer 131 and the second layer 132 may have different etching selectivity. For example, the first layer 131 may comprise a material having a high etching rate, and the second layer 132 may comprise a material having a low etching rate. Accordingly, when the first layer 131 and the second layer 132 are etched after a photosensitive pattern is formed on the second layer 132, the side portion of the first layer 131 may be etched faster than the side portion of the second layer 132, so that an undercut structure can be formed on the side portion of the protrusion part 130-1 and 130-2.

At least one of the first layer 131 or the second layer 132 may comprise a metal or a conductive oxide material having excellent electrical conductivity. Metals such as titanium (Ti), molybdenum (Mo), molybdenum-titanium (MoTi), aluminum (Al), copper (Cu), and alloys thereof may be used. Conductive oxide materials such as ITO and IZO may be used.

Meanwhile, by adjusting the target-source distance of the evaporation source (or the evaporation source device), the deposition material may be deposited on the substrate 110 at different deposition angles. The target-source distance may be the distance between the evaporation source and the substrate 110. The deposition angle may be the angle of the virtual line between the evaporation source and the lower edge 132a of the second layer 132 with respect to the normal direction. For example, the larger the target-source distance, the smaller the deposition angle can be. The smaller the deposition angle, the closer the layer formed by the deposition material may be deposited to the adjacent subpixel. The larger the deposition angle, the closer the corresponding layer may be deposited to the protrusion part 130-1 and 130-2.

As illustrated in FIGS. 4A, 4B, and 4C, since the deposition materials are deposited at different deposition angles, one end of the organic light-emitting layer 122r, 122g, and 122b and one end of the first conductive layer 123-1 of the cathode electrode 123r, 123g, and 123b may be positioned differently from each other.

The cathode electrode 123r, 123g, and 123b may comprise a plurality of conductive layers 123-1 and 123-2. For example, the cathode electrode 123r, 123g, and 123b may comprise a first conductive layer 123-1 and a second conductive layer 123-2 on the first conductive layer 123-1, but three or more conductive layers may be included.

One end of the organic light-emitting layer 122r, 122g and 122b and one end of the first conductive layer 123-1 may be positioned on the upper side of the bank 111-1 and 111-2. For example, one end of the organic light-emitting layer 122r, 122g and 122b may be positioned closer to the first layer 131 than one end of the first conductive layer 123-1.

The second conductive layer 123-2 may be disposed on the entire region of the substrate 110. The second conductive layer 123-2 may be deposited by using a sputtering process. That is, the second conductive layer 123-2 may be disposed on the upper side of the first conductive layer 123-1 of each of the subpixels SPr, SPg, and SPb, the upper side of the bank 111-1 and 111-2, and the side portion and upper side of the protrusion part 130-1 and 130-2. The second conductive layer 123-2 may be in contact with the side portion of the first layer 131 and/or the lower side of the second layer 132.

For example, the first conductive layer 123-1 may comprise a metal having excellent electrical conductivity, and the second conductive layer 123-2 may comprise a conductive oxide material. For example, the first conductive layer 123-1 may comprise a Mg:Ag alloy, and the second conductive layer 123-2 may comprise ITO, IZO, etc.

The Mg:Ag alloy may be formed as the first conductive layer 123-1 through deposition using an evaporation source. However, since the step coverage characteristics of Mg:Ag are not good, it is difficult for the deposition material comprising the Mg:Ag alloy to be deposited deep inside the undercut structure of the connection structure 105A. In addition, when the uniformity of the film thickness of the first conductive layer 123-1 comprising the Mg:Ag alloy is insufficient or the process margin is insufficient, the first conductive layer 123-1 may not be electrically connected to the auxiliary electrode AC included in the connection structure 105A, resulting in poor electrical connection.

To solve this problem, a conductive oxide material such as ITO having excellent step coverage characteristics may be deposited on the substrate 110 by using a sputtering process, so that it can be deposited deep inside the undercut structure of the connection structure 105A. Accordingly, the second conductive layer 123-2 may be stably deposited on the side portion of the first layer 131, which is the auxiliary electrode AC, so that electrical connection failure between the auxiliary electrode AC and the cathode electrode 123r, 123g, and 123b comprising the first conductive layer 123-1 and the second conductive layer 123-2 can be prevented. In addition, since the uniformity of the film thickness of the first conductive layer is secured, the stability of the production quality can be improved.

When the second conductive layer 123-2 is formed on the first conductive layer 123-1, there is no need to adjust or manage the deposition angle to deposit the first conductive layer 123-1 by using an evaporation source. In addition, even if the organic light-emitting layers 122r, 122g and 122b by using an evaporation source as well as the first conductive layer 123-1 are freely deposited regardless of the deposition angle, the organic light-emitting layers 122r, 122g and 122b can be deposited on the corresponding subpixels SPr, SPg and SPb, and the cathode electrodes 123r, 123g and 123b may be stably connected to the auxiliary electrodes AC of the protrusion parts 130-1 and 130-2 by the second conductive layer 123-2. Therefore, when configured by a combination of the aforementioned connection structure 105A and open structure 105B, productivity and material utilization efficiency can be improved through a freer deposition process.

In addition, when the organic light-emitting display device is implemented in a top emission manner, the luminescence efficiency may be improved by utilizing constructive interference between the anode electrode 121r, 121g and 121b and the cathode electrode 123r, 123g and 123b, by using the cathode electrode 123r, 123g and 123b comprising the first conductive layer 123-1 comprising the Ag:Mg alloy and the anode electrode 121r, 121g and 121b comprising the transflective material.

Meanwhile, the protrusion parts 130-1 and 130-2 may comprise a fourth layer 134 on the second layer 132. The fourth layer 134 may be omitted. The fourth layer 134 may comprise an inorganic material such as SiO₂, SiNx, SiONx. The fourth layer 134 may comprise a conductive oxide material such as ITO. The fourth layer 134 may act as a stopper for the second layer 132. As described above, in order to form a side-by-side structure, the red subpixel SPr, the green subpixel SPg, and the blue subpixel SPb may be etched twice, respectively. At this time, when these two etchings are performed, the area or thickness of the second layer 132 may change. In this instance, the deposition angle determined by the edge 132a on the lower side of the second layer 132 becomes different, so that the deposition areas of each subpixel SPr, SPg, and SPb become different, resulting in a decrease in image quality.

In order to solve the above-mentioned problem, when the fourth layer 134 that acts as a stopper is formed on the second layer 132, even if the etchings are performed twice, the etching of the second layer 132 may be suppressed or prevented by the fourth layer 134, so that the deposition angle determined by the edge 132a on the lower side of the second layer 132 may be fixed. Accordingly, since the deposition area in each of the subpixels SPr, SPg, and SPb may be secured as the target area, the image quality can be improved.

Although not illustrated, the third layer may be disposed below the first layer 131, but is not limited thereto. The third layer may comprise a material having a low etching rate. The third layer may comprise a metal or a conductive oxide material having excellent electrical conductivity. The third layer may comprise an inorganic material having an etching rate.

When the third layer comprises a metal or a conductive oxide material, the third layer may be an auxiliary electrode AC.

The etching rate of the third layer may be the same as or slower than the etching rate of the second layer 132. When the second layer 132 and the third layer are etched simultaneously, since the etching rate of the third layer is the same as or slower than the etching rate of the second layer 132, the side portion of the third layer may be positioned on the same vertical line as the side portion of the second layer 132 or may be disposed to extend further in the direction of the adjacent subpixel from the side portion of the second layer 132.

Meanwhile, the organic light-emitting display device according to the embodiment may comprise an encapsulation layer 135. The encapsulation layer 135 may be a blocking layer that prevents moisture, etc. from penetrating into the organic light-emitting element 120r, 120g, and 120b.

Meanwhile, the organic light-emitting display device according to the embodiment may comprise a plurality of color filter layers 140r, 140g, and 140b and a plurality of encapsulation layers 141r, 141g, and 141b.

The plurality of color filter layers 140r, 140g, and 140b may comprise a resin material. The plurality of encapsulation layers 141r, 141g, and 141b may comprise a plurality of layers. Some of the plurality of layers may comprise an inorganic material, and other layers may comprise an organic material.

The red color filter layer 140r may be disposed in the red subpixel SPr. The red color filter layer 140r may be disposed on the red organic light-emitting element 120r in the red subpixel SPr, so that only red light corresponding to a target red wavelength band set in the red color filter layer 140r among the wavelength bands of red light emitted from the red organic light-emitting element 120r may be emitted.

The green color filter layer 140g may be disposed in the green subpixel SPg. The green color filter layer 140g may be disposed on the green organic light-emitting element 120g in the green subpixel SPg, so that only green light corresponding to the target green wavelength band set for the green color filter layer 140g may be emitted among the wavelength bands of green light emitted from the green organic light-emitting element 120g.

The blue color filter layer 140b may be disposed on the blue subpixel SPb. The blue color filter layer 140b may be disposed on the blue organic light-emitting element 120b in the blue subpixel SPb, so that only blue light corresponding to the target blue wavelength band set for the blue color filter layer 140b may be emitted among the wavelength bands of blue light emitted from the blue organic light-emitting element 120b.

The plurality of color filter layers 140r, 140g and 140b may each have a color filter function that emits only color light of a preset wavelength band.

As described above, the plurality of color filter layers 140r, 140g and 140b may further enhance the color purity of each color compared to when there is no color filter layer, and in particular, may play a role in enhancing the change in color purity according to the viewing angle in an organic light-emitting display device having a top emission structure. Currently, a polarizing plate may be attached to remove light reflected by the reflective material of the anode electrode 121r, 121g, and 121b when external light is incident, but the most important role of the plurality of color filter layers 140r, 140g, and 140b is that the plurality of color filter layers 140r, 140g, and 140b may absorb external light to improve the contrast ratio and further contribute to cost reduction by removing the polarizing plate.

Meanwhile, the plurality of color filter layers 140r, 140g, and 140b may have the function of a photosensitive pattern for forming a pattern of the encapsulation layer 135, the cathode electrode 123r, 123g, and 123b, and the organic light-emitting layer 122r, 122g, and 122b, respectively.

As illustrated in FIG. 4A, the encapsulation layer 135, the cathode electrode 123r, and the red organic light-emitting layer 122r may be etched using the red color filter layer 140r, so that they may be formed only in the red subpixel SPr. In this instance, one end of the encapsulation layer 135, one end of the cathode electrode 123r, and one end of the red organic light-emitting layer 122r may be positioned on the same vertical line or diagonal line on the first protrusion part 130-1.

As illustrated in FIG. 4B, the encapsulation layer 135, the cathode electrode 123g, and the green organic light-emitting layer 122g may be etched using the green color filter layer 140g, so that they may be formed only in the green subpixel SPg. In this instance, one end of the encapsulation layer 135, one end of the cathode electrode 123g, and one end of the green organic light-emitting layer 122g on the first protrusion part 130-1 may be positioned on the same vertical line or diagonal line.

As illustrated in FIG. 4C, the encapsulation layer 135, the cathode electrode 123b, and the blue organic light-emitting layer 122b may be etched using the blue color filter layer 140b, so that they may be formed only the blue subpixel SPb. In this instance, one end of the encapsulation layer 135, one end of the cathode electrode 123b, and one end of the blue organic light-emitting layer 122b on the first protrusion part 130-1 may be positioned on the same vertical line or diagonal line.

As an example, the blue organic light-emitting element 120b, the green organic light-emitting element 120g, and the red organic light-emitting element 120r may be formed in that order, but is not limited thereto.

Meanwhile, the encapsulation layers 141r, 141g, and 141b may comprise a plurality of layers comprising organic materials or inorganic materials.

The encapsulation layers 141r, 141g, and 141b may protect the plurality of color filter layers 140r, 140g, and 140b made of resin materials from being etched. For example, when a blue encapsulation layer 141b is formed on a blue color filter layer 140b used for patterning a blue organic light-emitting element 120b, the blue encapsulation layer 141b may prevent the etching of the blue color filter layer 140b while the green organic light-emitting element 120g is etched. Similarly, when a green encapsulation layer 141g is formed on a green color filter layer 140g used for patterning a green organic light-emitting element 120g, the green encapsulation layer 141g may prevent the etching of the green color filter layer 140g while the red organic light-emitting element 120r is etched. Therefore, the red encapsulation layer 141r, the green encapsulation layer 141g, and the blue encapsulation layer 141b may serve as stoppers for preventing etching.

Meanwhile, the plurality of color filter layers 140r, 140g, and 140b may each comprise a light scattering agent or a light diffusing agent. Light may be scattered or diffused by the light scattering agent or the light diffusing agent, thereby improving luminescence efficiency.

Meanwhile, the red encapsulation layer 141r, the green encapsulation layer 141g, and the blue encapsulation layer 141b may each comprise a plurality of layers comprising an inorganic material and an organic material.

The red encapsulation layer 141r may be disposed on the red color filter layer 140r, the green encapsulation layer 141g may be disposed on the green color filter layer 140g, and the blue encapsulation layer 141b may be disposed on the blue color filter layer 140b.

The red encapsulation layer 141r, the green encapsulation layer 141g, and the blue encapsulation layer 141b may each comprise at least one or more layer. For example, the red encapsulation layer 141r, the green encapsulation layer 141g, and the blue encapsulation layer 141b may each comprise a first inorganic layer, an organic layer on the first inorganic layer, a second inorganic layer on the organic layer, etc., but are not limited thereto. The first inorganic layer and the second inorganic layer may comprise an inorganic material such as SiNx, and the organic layer may comprise a resin material, but are not limited thereto.

According to an embodiment, a plurality of subpixels SPr, SPg, and SPb may be sequentially formed to manufacture an organic light-emitting display device having a side-by-side structure. For example, a blue organic light-emitting element 120b, a blue color filter layer 140b, and a blue encapsulation layer 141b may be formed and patterned on the entire region of the substrate 110 using a photolithography process, so that a blue subpixel SPb may be formed. Then, a green organic light-emitting element 120g, a green color filter layer 140g, and a green encapsulation layer 141g may be formed and patterned on the entire region of the substrate 110 using a photolithography process, so that a green subpixel SPg may be formed. Then, a red organic light-emitting element 120r, a red color filter layer 140r, and a red encapsulation layer 141r may be formed and patterned using a photolithography process, so that a red subpixel SPr may be formed.

Meanwhile, in the first embodiment (FIGS. 1 and 2), the red organic light-emitting element 120r, the green organic light-emitting element 120g, and the blue organic light-emitting element 120b may be disposed in a stripe shape along the second direction Y.

In contrast, although not illustrated, the red organic light-emitting element 120r, the green organic light-emitting element 120g, and the blue organic light-emitting element 120b may be disposed spaced apart from each other in a dot shape. The red organic light-emitting element 120r may be disposed in the red subpixel SPr, the green organic light-emitting element 120g may be disposed in the green subpixel SPg, and the blue organic light-emitting element 120b may be disposed in the blue subpixel SPb. One pixel P may be configured by the red subpixel SPr, the green subpixel SPg, and the blue subpixel SPb.

For example, the red organic light-emitting element 120r and the green organic light-emitting element 120g may be isolated by one row line along the second direction Y, respectively. For example, the blue organic light-emitting element 120b may be isolated by two row lines along the second direction Y.

For example, the area of the blue organic light-emitting element 120b may be greater than the area of the red organic light-emitting element 120r or the red organic light-emitting element 120r. The length of the blue organic light-emitting element 120b in the second direction Y may be similar to the sum of the width of the red organic light-emitting element 120r and the width of the green organic light-emitting element 120g, but is not limited thereto.

In a pixel structure in which the red organic light-emitting element 120r, the green organic light-emitting element 120g, and the blue organic light-emitting element 120b are spaced apart from each other in a dot shape, there is no connection structure (105A of FIG. 4A) between the adjacent subpixels along the first direction X, but an asymmetric open-connection structure 105, that is, a connection structure 105A and an open structure 105B, may be provided at least two or more edges of each of the subpixels SPr, SPg, and SPb along the second direction Y.

FIG. 5 is a cross-sectional view illustrating an organic light-emitting display device according to a first embodiment. Although FIG. 5 illustrates the first bank 111-1 and the first protrusion part 130-1 in FIGS. 4A to 4C, the second bank 111-2 may also have the same structure or shape as the first bank 111-1 illustrated in FIG. 5. The remaining components not illustrated in FIG. 5 may also be illustrated in FIG. 5 in the same manner as the corresponding components illustrated in FIGS. 4A to 4C.

Referring to FIG. 5, the organic light-emitting display device according to the first embodiment may comprise a first bank 111-1, a first protrusion part 130-1, a red organic light-emitting element 120r, a green organic light-emitting element 120g, an open structure 105B, an encapsulation layer 135, a red color filter layer 140r, a red encapsulation layer 141r, a green color filter layer 140g, a green encapsulation layer 141g, etc.

Since the first bank 111-1, the open structure 105B, the red color filter layer 140r, the red encapsulation layer 141r, the green color filter layer 140g, and the green encapsulation layer 141g are described in FIGS. 4A to 4C, detailed descriptions are omitted.

The first protrusion part 130-1 may be disposed on the first bank 111-1. The red subpixel SPr and the green subpixel SPg may be distinguished by the first bank 111-1 and/or the first protrusion part 130-1. The red organic light-emitting element 120r may be disposed on the red subpixel SPr, and the green organic light-emitting element 120g may be disposed on the green subpixel SPg.

The red organic light-emitting element 120r may comprise an anode electrode, a red organic light-emitting layer 122r, a cathode electrode 123r, etc. The green organic light-emitting element 120g may comprise an anode electrode, a green organic light-emitting layer 122g, a cathode electrode 123g, etc.

The red organic light-emitting layer 122r of the red organic light-emitting element 120r and/or the green organic light-emitting layer 122g of the green organic light-emitting element 120g may be disposed to be spaced apart from the first protrusion part 130-1.

The cathode electrode 123r of the red organic light-emitting element 120r and the cathode electrode 123g of the green organic light-emitting element 120g may be electrically connected to the first protrusion part 130-1.

The encapsulation layer 135 may be disposed on the red organic light-emitting element 120r, the green organic light-emitting element 120g, and the first protrusion part 130-1. The encapsulation layer 135 may act as a blocking layer to prevent moisture, etc. from penetrating into the red organic light-emitting element 120r and the green organic light-emitting element 120g.

The encapsulation layer 135 may comprise a plurality of insulation layers 135-1 and 135-2, but is not limited thereto. For example, the encapsulation layer 135 may comprise the first-first insulation layer 135-1 and the first-second insulation layer 135-2 on the first-first insulation layer 135-1. For example, the first-first insulation layer 135-1 may be an inorganic layer comprising SiO₂, etc., and the first-second insulation layer 135-2 may be an inorganic layer comprising SiNx, etc., but are not limited thereto.

As illustrated in FIG. 5, the first-first insulation layer 135-1 may also be disposed inside the undercut structure 151 of the connection structure 105A. That is, the first-first insulation layer 135-1 may be disposed on the side portion of the first layer 131, the lower side of the second layer 132, etc. The first-second insulation layer 135-2 may not be disposed inside the undercut structure 151 of the connection structure 105A, but is not limited thereto.

The first protrusion part 130-1 may comprise the connection structure 105A comprising the auxiliary electrode AC. The auxiliary electrode AC may be electrically connected to the first power line PL1 via the contact pad 103 or directly, as illustrated in FIG. 3.

The first protrusion part 130-1 may comprise a first layer 131, a second layer 132, a third layer 133, a fourth layer 134, etc. For example, the second layer 132 may be disposed on the first layer 131, the third layer 133 may be disposed below the first layer 131, and the fourth layer 134 may be disposed on the second layer 132. The third layer 133 and/or the fourth layer 134 may be omitted.

At least one of the first layer 131, the second layer 132, or the third layer 133 may be an auxiliary electrode AC. Therefore, the cathode electrode 123r of the red organic light-emitting element 120r and the cathode electrode 123g of the green organic light-emitting element 120g may be electrically connected to at least one of the first layer 131, the second layer 132, or the third layer 133.

The first layer 131, the second layer 132, and the third layer 133 may have different etching selectivity. For example, the etching rate of the first layer 131 may be higher than the etching rate of the second layer 132 or the third layer 133. When the first layer 131, the second layer 132, and the third layer 133 are etched, the side portion of the first layer 131 is etched the fastest, so that the undercut structure 151 may be formed. That is, the side portion of the first layer 131 may be recessed into the inside of the first protrusion part 130-1 from the side portion of the second layer 132 or the second layer 133, so that the undercut structure 151 may be formed. The side portion of the third layer 133 may be positioned on the same line or diagonal line as the side portion of the second layer 132, or may extend in the direction of the subpixel SPr and SPg from the side portion of the second layer 132. In the deposition process using the evaporation source using the undercut structure 151 of the connection structure 105A, the red organic light-emitting layer 122r and the green organic light-emitting layer 122g may be disposed to be spaced apart from the first protrusion part 130-1, while the cathode electrodes 123r and 123g may be electrically connected to the auxiliary electrode AC.

Meanwhile, the first protrusion part 130-1 may comprise the bridge structure 105C. The bridge structure 105C may be disposed on the connection structure 105A or the auxiliary electrode AC.

The bridge structure 105C may comprise a bridge electrode 150. The bridge electrode 150 may be electrically connected to the first power line PL1 as illustrated in FIG. 3. In this instance, a second bridge electrode 150-2 of the bridge electrode 150 may be disposed in a non-emission region along the second direction Y, but is not limited thereto.

The bridge electrode 150 may comprise a first bridge electrode 150-1 and a second bridge electrode 150-2.

The second bridge electrode 150-2 may be disposed on the first bridge electrode 150-1 to be electrically connected to the first bridge electrode 150-1. For example, the second bridge electrode 150-2 may be electrically connected to the first bridge electrode 150-1 via the red encapsulation layer 141r or the green encapsulation layer 141g. For example, the red encapsulation layer 141r may be disposed on a portion of the upper side of the first bridge electrode 150-1, and the green encapsulation layer 141g may be disposed on another portion of the upper side of the first bridge electrode 150-1. The red encapsulation layer 141r and the green encapsulation layer 141g may be spaced apart from each other so that the first bridge electrode 150-1 may be exposed on the upper side of the first bridge electrode 150-1. Accordingly, the second bridge electrode 150-2 may contact the upper side of the exposed first bridge electrode 150-1.

The first bridge electrode 150-1 may comprise a material having excellent electrical conductivity or high etching resistance. For example, the first bridge electrode 150-1 may comprise a conductive oxide material such as ITO or a metal such as copper (Cu).

The second bridge electrode 150-2 may comprise a metal having excellent electrical conductivity or a low resistance metal. For example, the second bridge electrode 150-2 may comprise a metal such as aluminum (Al), titanium (Ti), copper (Cu), molybdenum-titanium (MoTi), or an alloy thereof. The first bridge electrode 150-1 and the second bridge electrode 150-2 may comprise the same metal, but are not limited thereto.

The first bridge electrode 150-1 may be a connection electrode for connecting the auxiliary electrode AC to the second bridge electrode 150-2. Accordingly, the second bridge electrode 150-2 may be electrically connected to the cathode electrodes 123r and 123g via the first bridge electrode 150-1 and the auxiliary electrode AC.

The first bridge electrode 150-1 may surround the second layer 132 of the connection structure 105A. For example, the first bridge electrode 150-1 may be disposed on the upper side, the side portion, and the lower side of the second layer 132.

The first bridge electrode 150-1 may surround the fourth layer 134 of the connection structure 105A. For example, the first bridge electrode 150-1 may be disposed on the upper side, the side portion, and the lower side of the fourth layer 134. The first bridge electrode 150-1 may be disposed on the lower side of the second layer 132 via the side portion of the fourth layer 134.

As described above, the auxiliary electrode AC may be electrically connected to the first power line PL1. In addition, the bridge electrode 150 may also be electrically connected to the first power line PL1. Accordingly, as illustrated in FIG. 3, the auxiliary electrode AC and the bridge electrode 150 may be commonly connected in parallel to the first power line PL1. Accordingly, a third resistor R3 and an eighth resistor R8 may be connected in series between the auxiliary electrode AC and the first power line PL1, and a seventh resistor R7 can also be connected between the auxiliary electrode AC and the first power line PL1. Therefore, the total resistance can be reduced by the third resistor R3 which are connected in parallel with the eighth resistor R8 and the eighth resistor R8. Thus, the current loss flowing through each of the red organic light-emitting element 120r and the green organic light-emitting element 120g may be reduced, thereby improving the luminescence efficiency and image quality and reducing power consumption.

Meanwhile, the first bridge electrode 150-1 or the fourth layer 134 of the first protrusion part 130-1 may also be used as an etch-stop layer. For this purpose, the first bridge electrode 150-1 or the fourth layer 134 may comprise a material having strong etching resistance. For example, the first bridge electrode 150-1 may comprise a conductive oxide material such as ITO. For example, the fourth layer 134 may comprise an insulating material such as Al₂O₃.

An organic deposition material for forming the organic light-emitting layer 122r and 122g, a deposition material for forming the cathode electrode 123r and 123g, and an organic or inorganic material for forming the encapsulation layer 135 may be formed through a dry etching process by using a gas such as CF₄, SF₆, O₂, Cl₂, etc. While these materials are dry etched, the first protrusion part 130-1 may also be etched, so that the size or shape of the first protrusion part 130-1 may be changed.

When the size or shape of the first protrusion part 130-1 is changed, the opening depth or opening gap of the undercut structure 151 of the connection structure 105A may be changed, which may affect the connection resistance (or contact resistance) between the auxiliary electrode AC and the cathode electrodes 123r and 123g. Accordingly, difference in the characteristics of the organic light-emitting elements of the subpixels SPr and SPg may occur, resulting in poor image quality, such as stains and color spot.

To solve this problem, the first bridge electrode 150-1 or the fourth layer 134 of the first protrusion part 130-1 may be used as an etch-stop layer. That is, the first bridge electrode 150-1 or the fourth layer 134 may comprise a material having strong etching resistance. In this instance, the etch-stop layer may protect the first protrusion part 130-1 from being etched by an etching gas such as CF₄ during the etching process, thereby preventing the size or shape of the first protrusion part 130-1 from being changed. Accordingly, the open depth or open gap of the undercut structure 151 of the connection structure 105A may be maintained as is, so that the difference in characteristics of the organic light-emitting elements of the subpixels SPr and SPg can be eliminated, thereby preventing poor image quality.

Meanwhile, the bridge structure 105C may comprise a black resin layer 151. The black resin layer 151 may be disposed on the bridge electrode 150. The black resin layer 151 may be disposed on the second bridge electrode 150-2.

The black resin layer 151 may be used as a black matrix (layer). Usually, a black matrix (layer) may be disposed between the subpixels, so that color mixing may be prevented. For this purpose, a black matrix (layer) may be provided separately between the subpixels.

However, according to the embodiment, since the black resin layer 151 is used as a black matrix (layer), there is no need to form a separate black matrix, so that the material cost can be reduced, the process can be simplified, and the product thickness can be reduced.

The side portion of the second bridge electrode 150-2 and the side portion of the black resin layer 151 may be positioned on the same vertical line or diagonal line. The black resin layer 151 may be used as a mask for forming the second bridge electrode 150-2. For example, the second bridge electrode 150-2 and the black resin layer 151 may be formed, and the second bridge electrode 150-2 may be etched using the black resin layer 151 as a mask, so that the side portion of the second bridge electrode 150-2 and the side portion of the black resin layer 151 can be positioned on the same vertical line or diagonal line. Afterwards, since the black resin layer 151 is not removed, the black resin layer 151 may be used as a black matrix (layer).

Meanwhile, a moisture penetration blocking structure may be formed by the bridge electrode 150 and the black resin layer 151. That is, since moisture penetration through the side portion of the first protrusion part 130-1 is blocked by the bridge electrode 150 and the black resin layer 151, image quality deterioration can be prevented and long lifespan can be achieved.

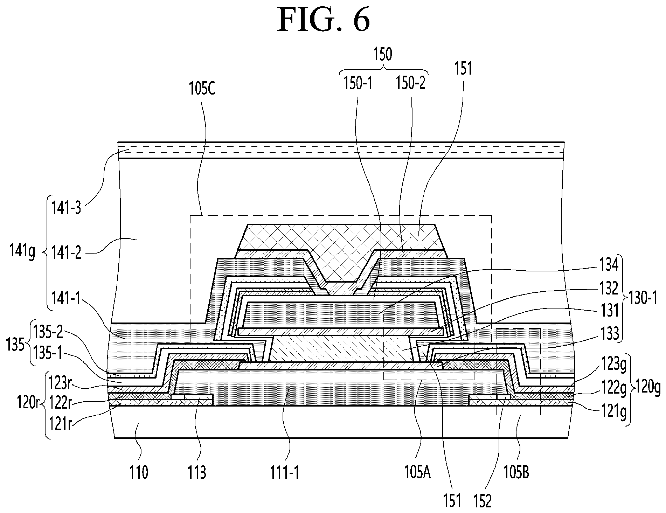

FIG. 6 is a cross-sectional view illustrating an organic light-emitting display device according to a second embodiment. FIG. 5 illustrates the first bank 111-1 and the first protrusion part 130-1 in FIGS. 4A to 4C, but the second bank 111-2 may also have the same structure or shape as the first bank 111-1 illustrated in FIG. 5. The remaining components not illustrated in FIG. 5 may also be illustrated in FIG. 5 in the same manner as the corresponding components illustrated in FIG. 4A to FIG. 4C.

The second embodiment is similar to the first embodiment except that the red color filter layer 140r and the green color filter layer 140g are omitted and the second encapsulation layer 141 comprises a plurality of insulation layers 141-1 to 141-3. In the second embodiment, components having the same shape, structure, and/or function as those in the first embodiment are given the same drawing reference numerals and detailed descriptions are omitted.

Referring to FIG. 6, the organic light-emitting display device according to the second embodiment may comprise a first bank 111-1, a first protrusion part 130-1, a red organic light-emitting element 120r, a green organic light-emitting element 120g, an open structure 105B, a first encapsulation layer 135, a second encapsulation layer 141, etc.

The first bank 111-1, the open structure 105B, and the first encapsulation layer 135 have been described in FIGS. 4A to 4C, and thus, a detailed description thereof will be omitted.

The first protrusion part 130-1 may comprise a connection structure 105A, a bridge structure 105C, etc. The connection structure 105A and the bridge structure 105C have been described in the first embodiment (FIG. 5), and thus, a detailed description thereof will be omitted.

The second encapsulation layer 141 may comprise a plurality of insulation layers 141-1 to 141-3. For example, the second encapsulation layer 141 may comprise a second-first insulation layer 141-1, a second-second insulation layer 141-2, and a second-third insulation layer 141-3.

The second-first insulation layer 141-1 may be disposed on the first encapsulation layer 135. That is, after the first encapsulation layer 135 is formed, the second-first insulation layer 141-1 may be formed on the first encapsulation layer 135. The second-first insulation layer 141-1 may comprise, for example, an inorganic material.

The second-first insulation layer 141-1 may be disposed on the red organic light-emitting element 120r and the green organic light-emitting element 120g. The second-first insulation layer 141-1 may be formed inside the undercut structure 151 of the connection structure 105A. The second-first insulation layer 141-1 may be disposed on the first bridge electrode 150-1 of the bridge electrode 150.

The second-first insulation layer 141-1 may be disposed on the first bridge electrode 150-1 to be spaced apart from each other so that the upper side of the first bridge electrode 150-1 may be exposed. Accordingly, the second bridge electrode 150-2 may be electrically connected to the upper side of the first bridge electrode 150-1 through the second-first insulation layer 141-1.

The second-second insulation layer 141-2 may be disposed on the second-first insulation layer 141-1. The second-second insulation layer 141-2 may comprise a resin material or an organic material. By performing an inkjet process using a resin material, the second-second insulation layer 141-2 may be formed on the second-first insulation layer 141-1.

The second-second insulation layer 141-2 may be formed after the second bridge electrode 150-2 and the black resin layer 151 are formed. Accordingly, the second bridge electrode 150-2 and the black resin layer 151 may be disposed between the second-first insulation layer 141-1 and the second-second insulation layer 141-2.

The second-second insulation layer 141-2 may be used as a planarization layer. The second-second insulation layer 141-2 may be formed thickly, for example, using a resin material, so that the upper surface of the second-second insulation layer 141-2 may have a flat surface.

The second-third insulation layer 141-3 may be disposed on the second-second insulation layer 141-2. The second-third insulation layer 141-3 may comprise an inorganic material such as SiNx. For example, by performing a PECVD process using an inorganic material, a second-third insulation layer 141-3 may be formed on a second-second insulation layer 141-2.

Therefore, since the second encapsulation layer 141 comprises a plurality of insulation layers 141-1 to 141-3, moisture penetration blocking performance can be enhanced.

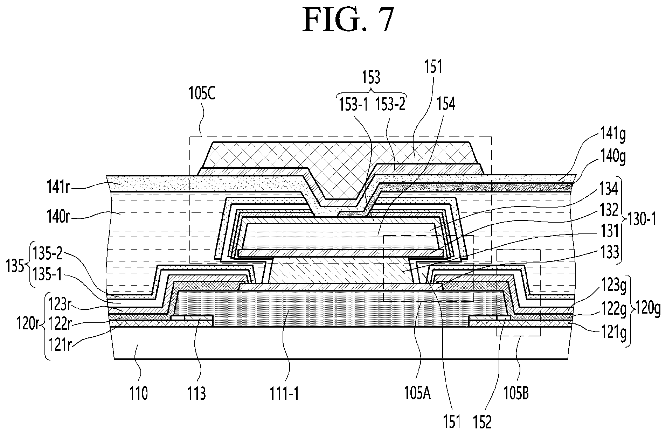

FIG. 7 is a cross-sectional view illustrating an organic light-emitting display device according to a third embodiment. Although FIG. 5 illustrates the first bank 111-1 and the first protrusion part 130-1 in FIGS. 4A to 4C, the second bank 111-2 may also have the same structure or shape as the first bank 111-1 illustrated in FIG. 5. The remaining components not illustrated in FIG. 5 may also be illustrated in FIG. 5 in the same manner as the corresponding components illustrated in FIGS. 4A to 4C.

The third embodiment may be identical to the first embodiment (FIG. 5) except for the bridge structure 105C comprising the sensing element 153. In the third embodiment, the same drawing reference numerals are given to components having the same shape, structure and/or function as those in the first embodiment, and detailed descriptions are omitted. The sensing element 153 of the third embodiment may also be applied to the second embodiment (FIG. 6) in the same manner.

Referring to FIG. 7, the organic light-emitting display device according to the third embodiment may comprise a first bank 111-1, a first protrusion part 130-1, a red organic light-emitting element 120r, a green organic light-emitting element 120g, an open structure 105B, an encapsulation layer 135, a red color filter layer 140r, a red encapsulation layer 141r, a green color filter layer 140g, a green encapsulation layer 141g, etc.

The first protrusion part 130-1 may comprise a connection structure 105A, a bridge structure 105C, etc.

The first protrusion part 130-1 may comprise a first layer 131, a second layer 132, a third layer 133, a fourth layer 134, etc. The first layer 131, the second layer 132, and the third layer 133 may have different etching selectivity. For example, the etching rate of the first layer 131 may be higher than the etching rate of the second layer 132 or the third layer 133. Accordingly, the side portion of the first layer 131 may be etched faster than the side portion of the second layer 132 or the side portion of the third layer 133, thereby forming an undercut structure 151.

Meanwhile, the third layer 133 may be used as an auxiliary electrode AC for electrically connecting with the cathode electrode 123r and 123g. For this purpose, the third layer 133 may comprise a metal having a low etching rate and excellent electrical conductivity.

The first layer 131 may serve to block the electrical connection between the third layer 133 and the sensing element 153. For this purpose, the first layer 131 may comprise a high etching rate and an insulating material. For example, the first layer 131 may comprise silicon nitride (SiNx), silicon oxide (SiOx), silicon nitride (SiON), etc.

The second layer 132 may comprise a metal or an insulating material. The fourth layer 134 may be used as an etch-stop layer.

Meanwhile, the bridge structure 105C may be disposed on the connection structure 105A or the auxiliary electrode AC.

The bridge structure 105C may comprise a sensing element 153 for touch sensing. The sensing element 153 may be disposed on the connection structure 105A or the auxiliary electrode AC. As described above, since the first layer 131 of the first protrusion part 130-1 may comprise an insulating material, the sensing element 153 may be not electrically connected to the first layer 131, which is the auxiliary electrode AC.

The sensing element 153 may comprise a first sensing electrode 153-1, a second sensing electrode 153-2, and a permittivity layer 153-3.

The first sensing electrode 153-1 may be disposed on the second layer 132 of the first protrusion part 130-1. The second sensing electrode 153-2 may be disposed on the first sensing electrode 153-1. The permittivity layer 153-3 may have a predetermined permittivity and may be disposed between the first sensing electrode 153-1 and the second sensing electrode 153-2.

The permittivity layer 153-3 may be a portion of the red encapsulation layer 141r. For example, the red encapsulation layer 141r may be disposed on the red subpixel SPr, the green subpixel SPg, and the first sensing electrode 153-1. The red encapsulation layer 141r may be disposed on the red color filter layer 140r in the red subpixel SPr, and on the green encapsulation layer 141g in the green subpixel SPr. The red encapsulation layer 141r may be disposed between the first sensing electrode 153-1 and the second sensing electrode 153-2 on the connection structure 105A. The red encapsulation layer 141r disposed between the first sensing electrode 153-1 and the second sensing electrode 153-2 may be used as the permittivity layer 153-3.

The red encapsulation layer 141r may have a predetermined permittivity. When a large electrostatic capacitance is required, the red encapsulation layer 141r may comprise a material having a high permittivity. Therefore, the red encapsulation layer 141r disposed between the first sensing electrode 153-1 and the second sensing electrode 153-2 may be used as the permittivity layer 153-3.

For touch sensing, one of the first sensing electrode 153-1 and the second sensing electrode 153-2 may supply a driving signal, and the other may output a sensing signal corresponding to the driving signal. The output sensing signal may be processed by a touch IC (integrated circuit) to obtain whether there is a touch or a touch coordinate, and a command for a touch may be performed based on the touch coordinate or a change in the touch coordinate.

In the sensing element 153, the first sensing electrode 153-1 or the second sensing electrode 153-2 may have a diamond shape when viewed from above, but is not limited thereto.

For example, the first sensing electrode 153-1 may be the first bridge electrode 150-1 illustrated in FIGS. 5 and 6, and the second sensing electrode 153-2 may be the second bridge electrode 150-2. The first sensing electrode 153-1 and the first bridge electrode 150-1 may be formed of the same material and have the same shape or structure. The second sensing electrode 153-2 and the second bridge electrode 150-2 may be formed of the same material and have the same shape or structure.

In the first embodiment (FIG. 5) and the second embodiment (FIG. 6), the bridge electrode 150 composed of the first bridge electrode 150-1 and the second bridge electrode 150-2 may play a role of reducing the resistance between the cathode electrode 123r and 123g and the first power line PL1.

In contrast, in the third embodiment (FIG. 7), the sensing element 153 may be not electrically connected to the cathode electrode 123r and 123g through the first layer 131 of the first protrusion part 130-1, and may play a role of sensing a touch based on the difference in electrostatic capacitance that changes when pressed by a human finger or a stylus pen. The electrostatic capacitance of the sensing element 153 may be determined by the permittivity of the permittivity layer 153-3. Since a difference in electrostatic capacitance occurs when a human finger or stylus pen touches or approaches the substrate and when it does not, whether or not a touch has occurred can be determined based on this difference in electrostatic capacitance.

The embodiment may implement a sensing element 153 of a self-capacitance method or a mutual-capacitance method. The sensing element 153 may be called a touch sensor, a touch cell, a touch node, etc.

Although not illustrated, the sensing element 153 may be arranged in a matrix. That is, a plurality of sensing elements 153 may be disposed on the auxiliary electrode AC of the first protrusion part 130-1 between the adjacent subpixels. To this end, one of the first sensing electrode 153-1 and the second sensing electrode 153-2 may be electrically connected to a first sensing line disposed along a first direction X, and the other may be electrically connected to a second sensing line disposed along a second direction Y. Accordingly, since a plurality of sensing elements 153 are positioned at a plurality of intersection points (or regions) where a plurality of first sensing lines disposed along the first direction X and a plurality of second sensing lines disposed along the second direction Y cross each other, a plurality of sensing elements 153 may be arranged in a matrix.

Although not illustrated, the sensing elements 153 may be separately provided on the second encapsulation layer 141 illustrated in FIG. 6. In this instance, the first layer 131 may also be used as an auxiliary electrode AC, so that the first layer 131 and the second layer 132 may be electrically connected to the bridge electrode 150.

## Claims

1. An organic light-emitting display device, comprising:
a bank between subpixels on a substrate;
an anode electrode on the subpixel;
an organic light-emitting layer on the anode electrode and the bank;
a cathode electrode on the organic light-emitting layer; and
a protrusion part disposed on an upper side of the bank so as to be spaced apart from the organic light-emitting layer;
wherein the protrusion part comprises:
a connection structure comprising an auxiliary electrode in contact with the cathode electrode; and
a bridge electrode disposed on the connection structure to be electrically connected to the auxiliary electrode.

2. The organic light-emitting display device of claim 1, wherein the protrusion part comprises:
a first layer on the bank;
a second layer on the first layer; and
a third layer below the first layer,
wherein a side portion of the third layer is positioned on a same line or diagonal line as a side portion of the second layer or is configured to extend from the side portion of the second layer in a direction of the subpixel, and
wherein a side portion of the first layer is recessed into the inside of the protrusion part from the side portion of the second layer.

3. The organic light-emitting display device of claim 2, wherein the bridge electrode comprises:
a first bridge electrode on the second layer; and
a second bridge electrode disposed on the first bridge electrode to be electrically connected to the first bridge electrode.

4. The organic light-emitting display device of claim 3, wherein the first bridge electrode is a connection electrode for connecting the auxiliary electrode to the second bridge electrode.

5. The organic light-emitting display device of claim 4, wherein the protrusion part further comprises:
a fourth layer between the second layer and the first bridge electrode.

6. The organic light-emitting display device of claim 5, wherein the first bridge electrode is disposed on a lower side of the second layer via a side portion of the fourth layer.

7. The organic light-emitting display device of claim 5, wherein at least one or more of the first bridge electrode or the fourth layer comprises an etch-stop layer.

8. The organic light-emitting display device of claim 2, wherein at least one of the first layer, the second layer, or the third layer is the auxiliary electrode.

9. The organic light-emitting display device of claim 2, wherein the protrusion part is disposed on the connection structure, and comprises a sensing element for touch sensing.

10. The organic light-emitting display device of claim 9, wherein the sensing element comprises:
a first sensing electrode on the second layer;
a second sensing electrode on the first sensing electrode; and
a permittivity layer having a predetermined permittivity between the first sensing electrode and the second sensing electrode.

11. The organic light-emitting display device of claim 10, wherein one of the first sensing electrode and the second sensing electrode is configured to supply a driving signal, and the other is configured to output a sensing signal corresponding to the driving signal.

12. The organic light-emitting display device of claim 1, further comprising:
a black resin layer on the bridge electrode.

13. The organic light-emitting display device of claim 1, wherein the auxiliary electrode and the bridge electrode are configured to be commonly connected to a power line.

14. The organic light-emitting display device of claim 1, further comprising:
an open structure configured to induce a hole injection layer of the organic light-emitting layer to be isolated in the bank.
